# EUROPÄISCHE PATENTSCHRIFT

(11) **EP 1 658 760 B1**
(45) Veröffentlichungstag und Bekanntmachung des Hinweises auf die Patenterteilung: **22.11.2006**
(21) Anmeldenummer: 04763654.3
(22) Anmeldetag: 30.07.2004
(51) Int. Cl.: H05K 5/06

(54) **VERGUSSSCHALE**
POTTING SHELL
COQUE D'ENCAPSULATION

(30) Priorität: 29.08.2003 DE 10340328
(43) Veröffentlichungstag der Anmeldung: 24.05.2006
(73) Patentinhaber: Endress + Hauser GmbH + Co. KG, 79689 Maulburg (DE)
(72) Erfinder: TANNER, Jürgen, 79400 Kandern (DE)
(74) Vertreter: Andres, Angelika Maria
(86) Internationale Anmeldenummer: PCT/EP2004/008573
(87) Internationale Veröffentlichungsnummer: WO 2005/029935

(56) Entgegenhaltungen:
- EP-A- 0 482 419
- EP-A- 0 641 154
- EP-A- 1 215 027
- US-A- 4 076 791
- US-A1- 2002 056 562

## Beschreibung

Die vorliegende Erfindung betrifft eine Vergußschale für eine bestückte Leiterplatte. Elektronische Schaltungen auf Leiterplatten werden in vielen Anwendungsfällen mit einer Vergußmasse vergossen, um beispielsweise die elektronische Schaltung vor Feuchteeinflüssen zu schützen und kritische Abstände zwischen Bauteilen einzuhalten. Hierzu wird die bestückte Leiterplatte entweder direkt in eine Gehäuse oder eine Vergußschale eingelegt, worauf das Gehäuse oder die Vergußschale mit der Vergußmasse aufgefüllt wird, bis der gewünschte Feuchteschutz gewährleistet ist.

Eine Vergußschale mit den Merkmalen des Oberbegriffs des Anspruchs 1 ist aus EP-A-0 482 419 bekannt.

Insofern, als die Vergußmasse einen anderen Wärmeausdehnungskoeffizienten aufweist als das umgebende Gehäuse oder als Komponenten der elektronischen Schaltung bzw. der Leiterplatte, können Temperaturschwankungen zu einer solchen Verformung der Leiterplatten führen, daß die elektronische Schaltung, die auf der Leiterplatte angeordnet ist, beschädigt wird. Dies gilt sowohl für Schaltungen, die in einem Gehäuse angeordnet sind, als auch für solche, die zunächst in einer herkömmlichen Vergußschale positioniert werden.

Es ist daher die Aufgabe der vorliegenden Erfindung, eine Vergußschale bereitzustellen, welche die geschilderten Nachteile überwindet.

Die Aufgabe wird erfindungsgemäß gelöst durch die Vergußschale gemäß des unabhängigen Patentanspruchs 1, das Elektronikmodul gemäß des unabhängigen Patentanspruchs 8 und den Meßumformer gemäß des unabhängigen Patentanspruchs 10.

Die erfindungsgemäße Vergußschale für eine elektronische Schaltung auf einer Leiterplatte umfaßt eine Wandanordnung, welche ein Schalenvolumen zumindest in einer Raumrichtung und in den dazu senkrechten Richtungen begrenzt, wobei die Leiterplatte in dem Schalenvolumen positionierbar ist und in dem Schalenvolumen mit einer Vergußmasse vergossen werden kann, wobei das Volumen zwischen der Leiterplatte und einer zumindest abschnittsweise im wesentlichen parallel zur Leiterplatte verlaufenden Hauptwand der Vergußschale mit Vergußmasse befüllbar ist, dadurch gekennzeichnet, daß die Hauptwand zumindest einen flexiblen Abschnitt aufweist, der geeignet ist, aufgrund einer Wärmeausdehnung der Vergußmasse senkrecht zu der Ebene des flexiblen Abschnitts verformt zu werden.

Die eine Raumrichtung, in welcher die Wandanordnung das Schalenvolumen begrenzt, kann beispielsweise nach unten sein, wobei dies in diesem Fall durch den Schalenboden gewährleistet wird. Die dazu senkrechten Richtungen werden durch Seitenwände seitlich begrenzt. Selbstverständlich sind auch andere Orientierungen der Vergußschale möglich, beispielsweise nachdem der Verguß ausgehärtet ist.

Die Hauptwand kann sowohl den Boden der Vergußschale als auch eine Seitenwand der Vergußschale umfassen. Die Vergußschale kann dementsprechend eine Öffnung aufweisen, durch welche die Leiterplatte mit ihrer Grundfläche in die Schale eingelegt werden kann, oder die Vergußschale kann eine schlitzartige Öffnung aufweisen, durch welche die Leiterplatte mit ihrer schmalen Seite in die Vergußschale eingeschoben werden kann.

Die Vergußschale kann beispielsweise als Spritzgußteil gefertigt sein, welches ein thermoplastisches und/oder thermoelastisches Material umfaßt. Die Wandstärke des Spritzgußteils außerhalb des flexiblen Abschnitts kann beispielsweise 1 mm bis 2 mm betragen. Die Wandstärke in dem flexiblen Abschnitt ist entsprechend dünner zu gestalten, wobei hier ggf. Forderungen nach festen Isolationsstrecken einzuhalten sind. Wenn beispielsweise 0,6 mm feste Isolationsstrecke erforderlich sind, und die Toleranz der Materialstärke 0,2 mm beträgt. So sollte die Sollstärke des flexiblen Abschnitts vorzugsweise 0,8 mm nicht unterschreiten. In einer derzeit bevorzugten Ausgestaltung beträgt die Wandstärke außerhalb des flexiblen Abschnitts 1 mm und innerhalb des flexiblen Abschnitts 0,8 mm.

Nach einer derzeit bevorzugten Ausgestaltung der Erfindung umfaßt der flexible Abschnitt eine geringere Wandstärke als andere Wandabschnitte der Vergußschale. Insbesondere kann die Fläche des flexiblen Abschnitts von einem Rahmen umgeben sein, welcher eine dickere Wandstärke aufweist, als der flexible Abschnitt.

Nach einer derzeit bevorzugten Ausgestaltung der Erfindung definiert die Außenseite der Hauptwand eine Stützfläche, mit welcher die Vergußschale auf einem Substrat, beispielsweise einer Gehäusewand eines Elektronikgehäuses, aufliegen kann, oder mit der sich die Vergußschale seitlich gegen ein Substrat abstützt. Die Stützfläche ist vorzugsweise zumindest abschnittsweise konvex bzw. planar. Der flexible Abschnitt ist bezüglich der Stützfläche zurückgesetzt. Das heißt, die Außenseite der flexiblen Stützfläche ist in Richtung des Schaleninneren verschoben. Auf diese Weise wird gewährleistet, daß der flexible Abschnitt nicht wie die Stützfläche an dem Substrat anliegt. Daher kann sich der flexible Abschnitt nach außen durchbiegen, um die Wärmeausdehnung der Vergußmasse senkrecht zur Ebene des flexiblen Abschnitts aufzunehmen.

Vorzugsweise ist der flexible Abschnitt so gestaltet, daß in seinem Zentrum mindestens 50 % der Wärmeausdehnung der Vergußmasse senkrecht zu der Ebene des flexiblen Abschnitts aufgenommen werden kann. Die Wärmeausdehnung bezieht sich hier auf den Temperaturbereich, für den die Schaltungen spezifiziert sind, beispielsweise von minus 40 Grad Celsius bis plus 85 Grad Celsius.

Die Wandstärke des flexiblen Abschnitts beträgt in einer bevorzugten Ausgestaltung der Erfindung nicht mehr als 80 % der Wandstärke außerhalb des flexiblen Abschnitts.

In einer Weiterbildung der Erfindung umfaßt die Wandanordnung der Vergußschale Öffnungen für elektrische Durchführungen, wobei diese Öffnungen von elastischen Dichtungen zumindest auf einer Seite der Wandanordnung umgeben sind. In einer derzeit bevorzugten Ausgestaltung sind die Öffnungen in der Hauptwand mit Dichtungen auf deren Außenseite vorgesehen. Die Dichtungen auf der Außenseite der Hauptwand setzen auf dem Substrat auf, wobei sie dort elektrische Anschlüsse oder Durchführungen für elektrische Anschlüsse in dem Substrat abdichten. Dichtungen auf der Innenseite der Hauptwand liegen an der Leiterplatte an, um einerseits das Eindringen von Vergußmasse in die Öffnungen zu verhindern und andererseits um das Eindringen von Feuchtigkeit durch die Öffnungen in die Vergußschale zu vermeiden.

Sofern es die Kontur der Schale erfordert, können die Dichtungen auf Vorsprüngen angeordnet sein, welche sich von der Hauptwand in das Innere des Schalenvolumens erstrecken.

Das erfindungsgemäße Elektronikmodul umfaßt eine elektronische Schaltung auf einer Leiterplatte, welche in der erfindungsgemäßen Vergußschale angeordnet und in dieser vergossen ist.

Die Erfindung eignet sich insbesondere für den Einsatz in Meßumformern, insbesondere der industriellen Prozeßmeßtechnik, da die elektronischen Schaltungen in diesem Einsatzgebiet sehr harschen Umgebungsbedingungen wie Temperaturschwankungen und einer hohen Luftfeuchtigkeit ausgesetzt sind. Typische Prozeßgrößen, die mit solchen Meßumformern erfaßt werden sind Druck, Differenzdruck, Füllstand, Durchfluß, Temperatur, pH-Wert, Red-Ox-Potentiale, Feuchte, Trübung, oder ein gelöster Gasgehalt in einer Flüssigkeit. Die Liste der Prozeßparameter dient nur zur Erläuterung und nicht zur Begrenzung des Schutzbereiches der vorliegenden Erfindung.

Weitere Einzelheiten ergeben sich aus der Beschreibung des in den Figuren gezeigten Ausführungsbeispiels.

Es zeigt:
- Fig. 1:: Eine Aufsicht auf eine erfindungsgemäße Vergußschale; und
- Fig. 2:: eine Schnittansicht entlang der Linie II-II aus Fig. 2, wobei die Vergußschale mit einer Leiterplatte bestückt und in ein Gehäuse eingesetzt ist.

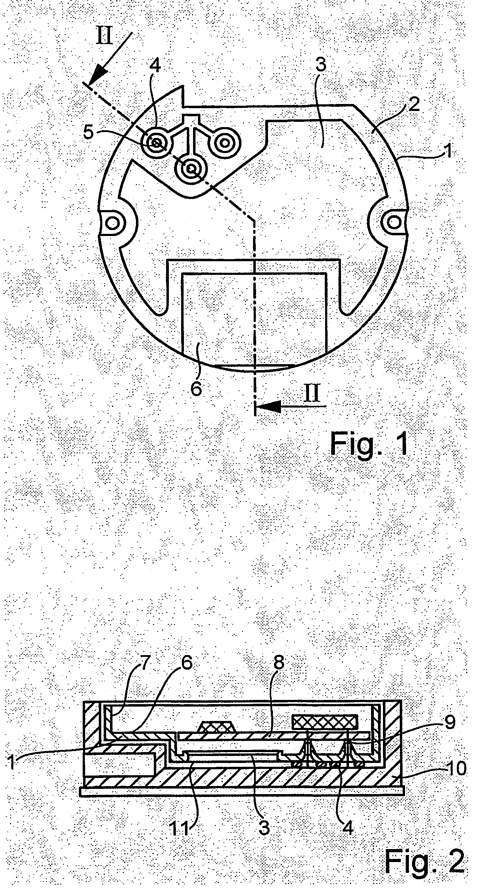

Die in Fig. 1 und Fig. 2 gezeigte Vergußschale umfaßt eine Wandanordnung mit einem planaren Bodenrahmen 2, welcher eine Stützfläche definiert, mit welcher die Vergußschale auf dem Boden 11 einer Elektronikkammer in einem Gehäuse 10 aufsitzt. Die Vergußschale ist seitlich von einem umlaufenden Rand 7 begrenzt, der sich im wesentlichen senkrecht zu der Ebene des Rahmens 2 erstreckt. In dem Rahmen 2 ist ein flexibler Abschnitt 3 angeordnet, welcher im wesentlichen parallel zur Ebene der Stützfläche verläuft und bezüglich dieser zurückgesetzt ist.

Die Wandstärke des flexiblen Abschnitts beträgt etwa 80 % der Wandstärke des Bodenrahmens 2, so daß sich das flexible Element bei ggfs. auftretenden Wärmeausdehnungen einer Vergußmasse leichter verformen kann.

Zudem ist durch das Zurücksetzen des flexiblen Elements 3 hinreichend Raum zwischen dem Boden der Elektronikkammer und dem flexiblen Abschnitt 3 vorhanden, so daß der flexible Abschnitt bei einer Verformung nicht auf dem Boden 11 aufsetzen wird.

Soweit erforderlich, kann die Wandanordnung der Vergußschale auch Stufen aufweisen, wie im Ausführungsbeispiel anhand des Sockels 6 dargestellt ist. Die Hauptwand umfaßt somit neben dem Rahmen und dem flexiblen Abschnitt 3 einen zweiten Abschnitt 6, der im Bedarfsfall selbstverständlich auch als flexibler Abschnitt gestaltet werden kann. Im Boden der Vergußschale 1 sind drei Öffnungen 5 angeordnet, welche zur Durchführung von elektrischen Kontakten 9.zur Leiterplatte 8 vorgesehen sind. Die Öffnungen 5 sind von elastischen Dichtungen 4 umgeben, welche im Ausführungsbeispiel miteinander vemetzt sind, um die Fertigung zu vereinfachen.

Auf der Innenseite des Rahmens 2 sind um die Öffnungen 5 Vorsprünge angeordnet, welche sich in das Schaleninnere erstrecken, wobei auf der Stirnseite Vorsprünge elastische Dichtungen vorgesehen sind, welche die Öffnungen umgeben. Auf diesen Öffnungen liegt die Leiterplatte 8 auf. Die Vergußschale 1 ist mindestens bis zur Unterseite der Leiterplatte mit Vergußmasse gefüllt.

Durch die Dichtungen auf der Stirnseite der Vorsprünge wird gewährleistet, daß die Vergußmasse nicht in die Öffnungen 5 eindringen und diese verschließen kann, sofern eine Kontaktierung erst nach dem Vergießen erfolgen soll. Zudem dienen die Dichtungen, wie eingangs erwähnt, als Feuchtigkeitsbarierren.

## Patentansprüche

1. Vergußschale (1) für eine bestückte Leiterplatte, wobei die Vergußschale eine Wandanordnung aufweist, welche ein Schalenvolumen zumindest in einer Raumrichtung und in den dazu senkrechten Richtungen begrenzt, wobei die Leiterplatte in dem Schalenvolumen positionierbar ist und in dem Schalenvolumen mit einer Vergußmasse vergossen werden kann, wobei das Volumen zwischen der Leiterplatte und einer zumindest abschnittsweise im wesentlichen parallel zur Leiterplatte verlaufenden Hauptwand der Vergußschale mit Vergußmasse befüllbar ist, **dadurch gekennzeichnet, daß** die Hauptwand zumindest einen flexiblen Abschnitt (3) aufweist, der geeignet ist, aufgrund einer Wärmeausdehnung der Vergussmasse senkrecht zu der Ebene des flexiblen Abschnitts verformt zu werden.

2. Vergußschale nach Anspruch 1, wobei der flexible Abschnitt eine geringere Wandstärke aufweist, als andere Wandabschnitte der Vergußschale.

3. Vergußschale nach Anspruch 2, wobei die Wandstärke in dem flexiblen Abschnitt nicht mehr als 80% der Wandstärke außerhalb des flexiblen Abschnitts umfaßt.

4. Vergußschale nach einem der Ansprüche 1 bis 3, wobei die Außenseite der Hauptwand eine zumindest Stützfläche definiert, und wobei der zumindest eine flexible Abschnitt bezüglich der Stützfläche zurückgesetzt ist.

5. Vergußschale nach einem der vorhergehenden Ansprüche, wobei der flexible Abschnitt geeignet ist, in seinem Zentrum mindestens 50% der Wärmeausdehnung der Vergußmasse senkrecht zu der Ebene des flexiblen Abschnitts aufzunehmen.

6. Vergußschale nach einem der vorhergehenden Ansprüche, wobei die Hauptwand außerhalb des flexiblen Abschnitts mindestens eine Öffnungen für elektrische Durchführungen aufweist, wobei die mindestens eine Öffnung an an der Außenseite der Vergußschale und/oder an deren Innenseite von einer elastischen Dichtung umgeben ist.

7. Vergußschale nach Anspruch 6, wobei die mindestens eine Öffnung auf der Innenseite von einem Vorsprung umgeben ist, der sich von der Hauptwand in das innere der Vergußschale erstreckt, und wobei die elastische Dichtung welche auf dem Vorsprung angeordnet ist.

8. Elektronikmodul, umfassend, eine bestückte Leiterplatte, die in einer Vergußschale gemäß der Ansprüche 1 bis 7 angeordnet und in dieser mit Vergußmasse vergossen ist.

9. Elektronikmodul, nach Anspruch 8, umfassend, eine bestückte Leiterplatte, die in einer Vergußschale gemäß des Anspruchs 6 oder 7 angeordnet ist, wobei die Leiterplatte gegen die Dichtung auf der Innenseite der Vergußschale drückt.

10. Meßumformer zum Erfassen einer Prozeßgröße, umfassend ein Gehäuse, in dem ein Elektronikmodul gemäß der Ansprüche 8 oder 9 angeordnet ist.

11. Meßumformer nach Anspruch 10, wobei die Prozeßgröße, Druck, Differenzdruck, Füllstand, Durchfluß, Temperatur, pH-Wert, Red-Ox-Potential, Feuchte, Trübung, oder ein Gasgehalt in einer Flüssigkeit sein kann.

## Claims

1. Potting shell (1) for a populated circuit board, wherein the potting shell has a wall arrangement, which defines a shell volume at least in one spatial direction, and in the directions perpendicular thereto; wherein the circuit board is positionable in the shell volume, and can be potted in the shell volume with a potting compound; wherein the volume between the circuit board and a main wall of the potting shell, running essentially parallel, at least sectionally, to the circuit board, can be filled with potting compound; **characterized in that** the main wall has at least one flexible section (3), which, based on a thermal expansion of the potting compound, can be deformed perpendicular to the plane of the flexible section.

2. Potting shell as claimed in claim 1, wherein the flexible section has a lesser wall thickness than other wall sections of the potting shell.

3. Potting shell as claimed in claim 2, wherein the wall thickness in the flexible section amounts to not more than 80% of the wall thickness outside of the flexible section.

4. Potting shell as claimed in one of the claims 1 through 3, wherein the exterior side of the main wall defines at least one support surface, and wherein the at least one flexible section is recessed with respect to the support surface.

5. Potting shell as claimed in one of the preceding claims, wherein the flexible section, in its center, can absorb at least 50% of the thermal expansion of the potting compound perpendicular to the plane of the flexible section.

6. Potting shell as claimed in one of the preceding claims, wherein the main wall, outside of the flexible section, has at least one opening for electrical feed-throughs, wherein the at least one opening is surrounded on the exterior side of the potting shell, and/or on its interior side, by an elastic seal.

7. Potting shell as claimed in claim 6, wherein the at least one opening is surrounded on the interior side by a protrusion, which extends from the main wall into the interior of the potting shell, and wherein the elastic seal is arranged on the protrusion.

8. Electronics module, comprising a populated circuit board, which is arranged in a potting shell as claimed in claims 1 through 7, and is potted therein with potting compound.

9. Electronics module, as claimed in claim 8, comprising a populated circuit board, which is arranged in a potting shell as claimed in claim 6 or 7, wherein the circuit board presses against the seal on the interior side of the potting shell.

10. Measuring transmitter for registering a process parameter, comprising a housing, in which an electronics module, as claimed in claim 8 or 9, is arranged.

11. Measuring transmitter as claimed in claim 10, wherein the process parameter comprises pressure, pressure difference, fill level, flow rate, temperature, pH-value, redox potential, humidity, turbidity, or gas content in a liquid.

## Revendications

1. Coque de scellement (1) destinée à un circuit imprimé équipé, la coque de scellement présentant une configuration de parois, laquelle limite le volume de la coque au moins dans une direction de l'espacé et dans les directions perpendiculaires à cette première, le circuit imprimé pouvant être positionné dans le volume de la coque et pouvant être scellé dans le volume de la coque au moyen d'une masse de scellement, le volume entre le circuit imprimé et une paroi principale, qui est essentiellement parallèle, au moins par parties, au circuit imprimé, de la coque de scellement pouvant être rempli de masse de scellement, **caractérisée en ce que** la paroi principale présente au moins une partie flexible (3) qui, suite à une dilatation thermique de la masse de scellement, est capable de se déformer perpendiculairement au plan de la partie flexible.

2. Coque de scellement selon la revendication 1, la partie flexible présentant une épaisseur de paroi plus faible que les autres segments de paroi de la coque de scellement.

3. Coque de scellement selon la revendication 2, l'épaisseur de paroi au niveau de la partie flexible ne représentant pas plus de 80 % de l'épaisseur de paroi en dehors de la partie flexible.

4. Coque de scellement selon l'une des revendications 1 à 3, pour laquelle la face extérieure de la paroi principale forme au moins une surface d'appui, et au moins une partie flexible est en retrait par rapport à la surface d'appui.

5. Coque de scellement selon l'une des revendications précédentes, la partie flexible étant apte, en son centre, à absorber au moins 50 % de la dilatation thermique de la masse de scellement, perpendiculairement au plan de la partie flexible.

6. Coque de scellement selon l'une des revendications précédentes, pour laquelle la paroi principale présente à l'extérieur de la partie flexible au moins une ouverture pour les traversées électriques, cette ouverture étant entourée d'un joint élastique sur la face extérieure de la coque de scellement et/ou sur sa face intérieure.

7. Coque de scellement selon la revendication 6, pour laquelle au moins une ouverture est entourée, sur sa face intérieure, d'une partie en saillie, laquelle s'étend de la paroi principale vers l'intérieur de la coque de scellement, le joint élastique étant disposé sur la partie en saillie.

8. Module électronique, comprenant un circuit imprimé équipé, qui est disposé dans une coque descellement conformément aux revendications 1 à 7 et est scellé dans cette dernière au moyen de masse de scellement.

9. Module électronique, selon la revendication 8, comprenant un circuit imprimé équipé, qui est disposé dans une coque de scellement selon la revendication 6 ou 7, le circuit imprimé pressant le joint contre la face intérieure de la coque de scellement.

10. Transmetteur destiné à la mesure d'une grandeur process, comprenant un boîtier, dans lequel est disposé un module électronique conformément à la revendication 8 ou 9.

11. Transmetteur selon la revendication 10, la grandeur process pouvant être une pression, une pression différentielle, un niveau, un débit, une température, un pH, un potentiel Redox, une humidité, une turbidité ou une teneur en gaz dans un liquide.
